# EUROPEAN PATENT SPECIFICATION

(11) **EP 3 450 594 B1**
(45) Date of publication and mention of the grant of the patent: **22.07.2020**
(21) Application number: 16900517.0
(22) Date of filing: 25.04.2016
(51) Int. Cl.: C30B 29/20, C30B 11/10, C30B 15/00, C30B 33/02

(54) **BLUE-COLORED ALUMINUM OXIDE SINGLE CRYSTAL AND METHOD FOR PRODUCING ALUMINUM OXIDE SINGLE CRYSTAL**
BLAUGEFÄRBTER ALUMINIUMOXID-EINKRISTALL UND VERFAHREN ZUR HERSTELLUNG EINES ALUMINIUMOXID-EINKRISTALLS
MONOCRISTAL D'OXYDE D'ALUMINIUM DE COULEUR BLEUE ET PROCÉDÉ DE PRODUCTION D'UN MONOCRISTAL D'OXYDE D'ALUMINIUM

(43) Date of publication of application: 06.03.2019
(73) Proprietor: Shinkosha Co., Ltd., Yokohama-shi Kanagawa 247-0007 (JP)
(72) Inventor: TAKAHASHI, Maki, Yokohama-shi Kanagawa 247-0007 (JP); ASAKA, Shohei, Yokohama-shi Kanagawa 247-0007 (JP); KAWAMINAMI, Shuichi, Yokohama-shi Kanagawa 247-0007 (JP)
(74) Representative: Strehl Schübel-Hopf & Partner
(86) International application number: PCT/JP2016/063616
(87) International publication number: WO 2017/187647

(56) References cited:
- CN-A- 101 941 727
- JP-A- S60 191 098
- JP-A- S60 231 490
- JP-A- 2008 031 019
- JP-A- 2011 524 326
- KR-B1- 100 856 109
- RU-C1- 2 049 832
- Robert E Izane ET AL: "THE IDENTIFICATION OF BLUE DIFFUSION-TREATED SAPPHIRES", Gems & Gemology, vol. 26, no. 2 1 June 1990 (1990-06-01), pages 115-133, XP055649155, Retrieved from the Internet: URL:https://www.gia.edu/doc/the_identifica tion_of_blue_diffusion_treated_sapphires.p df [retrieved on 2019-12-04]
- SAITO, YUKINORI et al.: "Coloration of sapphire by Co ion implantation", Nuclear Instruments and Methods in Physics Research Section B:Beam Interactions with Materials and Atoms, vol. 59 -60, 1991, pages 1173-1176, XP055067488, ISSN: 0168-583X
- KEIG, G.A.: "Influence of the valence state of added impurity ions on the observed color in doped aluminum oxide single crystals", Journal of crystal growth, vol. 2, 1968, pages 356-360, XP024420300, ISSN: 0022-0248

## Description

### Technical Field

The present invention relates to an aluminum oxide single crystal having a blue color, and a method for producing the aluminum oxide single crystal.

### Background Art

Natural blue sapphire is known to contain iron and titanium. Moreover, since a long time ago, blue sapphire has been industrially produced by causing iron and titanium serving as color formers to be dissolved as solid solution in the crystal. It is known that when iron and titanium serving as color formers are dissolved as solid solution in the crystal, the resulting blue sapphire has a reddish blue color (PTL 1).

Also proposed is a production method that involves dissolving nickel as a color former in the crystal in addition to iron and titanium so that a sky blue color free of a red tinge is formed (PTL 2). Blue sapphire containing cobalt and showing absorption peaks at 550, 590, and 620 nm and as well 375, 388, 410, 450 and 479 obtained by diffusion are known (NPL 2).

Meanwhile, it is known that a blue color is formed by causing cobalt to be dissolved as solid in the crystal by an ion implantation method, such as sputtering. According to the ion implantation method, cobalt is dissolved as solid solution only in the surface of the crystal and the vicinity thereof (PTL 3 and NPL 1).

### Citation List

### Patent Literature

[PTL 1]: Japanese Patent No. 3940581
[PTL 2]: Japanese Patent No. 4828285
[PTL 3]: Japanese Patent No. 5463352

### Non Patent Literature

[NPL 1]: Nuclear Instruments and Methods in Physics Research Section B: Beam Interactions with Materials and Atoms, Volumes 59-60, Part 2, 1 July 1991, Pages 1173-1176
[NPL 2]: R. Kane et al, "the identification of blue diffusion-treated sapphires", Gems & Gemology, Vol. 26 N. 2, (1.6.1990) 115-133.

### Summary of Invention

### Technical Problem

An aluminum oxide single crystal that has a bright blue color, such as a color called sky blue or marine blue, and has a blue color even in the inside of the crystal has not reported so far.

An aluminum oxide single crystal in which iron and titanium are dissolved as solid solution and as color formers has a broad absorption band from 450 nm to 700 nm. Thus, this aluminum oxide single crystal transmits blue light having a wavelength of 400 nm to 450 nm, and has a deep dark blue color with a slight purple tinge. This color formation is considered to result from charge-transfer involving iron and titanium, does not happen by merely dissolving iron as solid solution, and requires presence of a quadrivalent titanium.

The problem with having multiple color formers are dissolved as solid solution in the crystal of the aluminum oxide single crystal has been that the color formers are likely to segregate in the outer peripheral portion of the crystal and make the color of the aluminum oxide single crystal uneven, and that thus it is difficult to obtain an aluminum oxide single crystal that has a bright color.

Moreover, when cobalt is dissolved as solid solution in the crystal by an ion implantation method, the surface portion of the crystal turns blue, but the inside of the crystal does not turn blue. Thus, it has not been possible to obtain an aluminum oxide single crystal that is blue even in the inside of the crystal. In addition, since ion implantation equipment is expensive and has low throughput, the productivity for the desired aluminum oxide single crystals is low.

An object of the present invention is to provide, at an industrially appropriate cost, an aluminum oxide single crystal having a bright blue color, such as a color called sky blue or marine blue, even in the inside of the crystal.

### Solution to Problem

In order to obtain an aluminum oxide single crystal having a blue color, experiments were conducted by using various dopants and by changing the amounts of the dopants. As a result, it has been found that an aluminum oxide single crystal that contains 50 ppm to 130 ppm of cobalt relative to the number of aluminum atoms has a blue color.

This aluminum oxide single crystal, as disclosed in claim 1, is characterized by having absorption peaks at wavelengths of 440 nm, 550 nm, 590 nm, and 630 nm, and by absorbing light having a wavelength of 510 nm to 740 nm. Moreover, the aluminum oxide single crystal is characterized in that an absorption coefficient α is 60 m⁻¹ to 570 m⁻¹ at an absorption wavelength of 590 nm.

A method for producing an aluminum oxide single crystal according to the present invention, as disclosed in claim 2, is characterized in that an aluminum oxide single crystal having a blue color is grown by a flame fusion method from a raw material containing aluminum oxide as a main raw material and cobalt mixed thereto so that the concentration thereof is 1700 ppm to 13700 ppm relative to the number of aluminum atoms. Alternatively, as disclosed in claim 3, a method for producing an aluminum oxide single crystal according to the present invention is characterized in that an aluminum oxide single crystal having a blue color is grown by a Rotating and pulling method from a raw material containing aluminum oxide as a main raw material and having a cobalt concentration of 5000 ppm to 20000 ppm relative to the number of aluminum atoms.

A method for producing an aluminum oxide single crystal according to the present invention is characterized in that, after growing an aluminum oxide single crystal by a flame fusion method or a Rotating and pulling method, a heat treatment is performed at a predetermined temperature in an atmosphere having an oxygen partial pressure of 10⁻⁶ atm to 10⁻⁹ atm. Here, the predetermined temperature refers to a temperature equal to or higher than 1400°C and equal to or lower than the melting point of the aluminum oxide single crystal, and, since it is often difficult to control the atmosphere at high temperature due to limitations posed by furnace materials and the like, the temperature is preferably equal to or lower than 1800°C.

### Advantageous Effects of Invention

The present invention provides an aluminum oxide single crystal that has a cobalt concentration of 50 ppm to 130 ppm relative to the number of aluminum atoms and has a blue color. This aluminum oxide single crystal has no red tinge and is blue even in the inside of the crystal.

The aluminum oxide single crystal according to the present invention has absorption peaks at wavelengths of 440 nm, 550 nm, 590 nm, and 630 nm, and absorbs light having a wavelength of 510 nm to 740 nm; thus, the aluminum oxide single crystal absorbs green, yellow, and red light and has an intense, bright blue color.

The aluminum oxide single crystal according to the present invention has an absorption coefficient α of 60 m⁻¹ to 570 m⁻¹ at an absorption wavelength of 590 nm, absorbs yellow light, and has an intense blue color, which is complementary to yellow.

In the method for producing an aluminum oxide single crystal according to the present invention, an aluminum oxide single crystal having a cobalt concentration of 50 ppm to 130 ppm relative to the number of aluminum atoms and having a blue color can be produced by growing a single crystal by a flame fusion method from a raw material containing aluminum oxide as a main raw material and having a cobalt concentration of 1700 ppm to 13700 ppm relative to the number of aluminum atoms.

In the method for producing an aluminum oxide single crystal according to the present invention, an aluminum oxide single crystal having a cobalt concentration of 60 ppm to 110 ppm relative to the number of aluminum atoms and having a blue color can be produced by growing a single crystal by a Rotating and pulling method from a raw material having a cobalt concentration of 5000 ppm to 20000 ppm relative to the number of aluminum atoms.

Moreover, an aluminum oxide single crystal having no red tinge but a bright blue color even in the inside can be obtained by performing a heat treatment at a predetermined temperature in an atmosphere having an oxygen partial pressure of 10⁻⁶ to 10⁻⁹ atm after a crystal is grown from the raw material.

A sapphire that is blue even in the inside can be produced by the production method described above by using only cobalt as a color former. Thus, a blue sapphire of a practical size for use in accessories, watches, etc., can be produced at an appropriate cost.

### Brief Description of Drawings

Fig. 1 is a graph showing the results of transmittance measurement performed on an aluminum oxide single crystal according to an embodiment of the present invention.
Fig. 2 is a graph showing the results of transmittance measurement performed on aluminum oxide single crystals according to an embodiment of the present invention.

### Description of Embodiments

Embodiments related to the present invention are described below in detail. These embodiments are merely examples that embody the features of the present invention, and various design modifications are possible without departing from the matters described in the claims.

### First embodiment

A method for producing an aluminum oxide single crystal according to this embodiment involves generating an aluminum oxide single crystal through a process of growing a single crystal by a flame fusion method from a raw material which contains aluminum oxide as a main raw material and has a cobalt concentration of 1700 ppm to 13700 ppm relative to the number of aluminum atoms, and, after the process of growing the single crystal, a process of performing a heat treatment at a temperature of 1500°C in an atmosphere having an oxygen partial pressure of 10⁻⁹ atm.

Aluminum oxide and cobalt oxide were used as the raw materials for the aluminum oxide single crystal.

### (Example 1 to Example 5)

A raw material (starting material) was prepared by mixing cobalt oxide with aluminum oxide so that the cobalt concentration relative to the number of aluminum atoms was 1700 ppm to 13700 ppm. Then, a single crystal was grown from this raw material by a flame fusion method using oxyhydrogen flame.
Crystal growth direction: [11-20]
Crystal growth rate: 10 mm/h

Next, a sample having a thickness of 3 mm was prepared by cutting and polishing this single crystal so that the a-plane constituted a flat surface.

Then, the sample was heat-treated at 1500°C for 50 hours in a tubular electric furnace formed of a high-purity alumina tube while causing a gas having a predetermined oxygen partial pressure (10⁻⁹ atm) to flow.

The oxygen partial pressure was adjusted by adding a predetermined proportion of hydrogen + water steam to nitrogen gas.

### (Comparative Example 1 to Comparative Example 3)

In Comparative Example 1, a raw material having a cobalt concentration of 850 ppm relative to the number of aluminum atoms was prepared. Then, under the same conditions as Examples 1 to 5, a crystal was grown from the raw material by a flame fusion method, and was heat-treated. In Comparative Example 2, a raw material having a cobalt concentration of 6400 ppm relative to the number of aluminum atoms was prepared, and a crystal was grown from the raw material by a flame fusion method. However, a heat-treatment was not carried out after the crystal had been grown. In Comparative Example 3, a raw material having an iron concentration of 300 ppm and a titanium concentration of 600 ppm relative to the number of aluminum atoms was prepared, and a crystal was grown from the raw material by a flame fusion method. However, a heat-treatment was not carried out after the crystal had been grown. Observation of color, measurement of the transmittance, and the ICP analysis were performed on the aluminum oxide single crystals obtained in Examples and Comparative Examples. The results are shown in Table 1. In Table 1, the figures of cobalt concentrations in parentheses are estimate values determined from working curves for the ICP analysis values and the transmittances obtained by performing transmittance measurement. The working curves were obtained from the ICP analysis values and the transmittance at a wavelength of 440 nm obtained by performing the transmittance measurement and the ICP analysis on four samples after heat-treated in air at 1650°C.

**[Table 1]**

| | Cobalt concentration in raw material composition ppm(at) | Heat treatment temperature (°C) | Heat treatment atmosphere (pO₂: atm) | Color of crystal | Cobalt concentration ICP analysis value ppm (at) | Absorption coefficient α (m⁻¹) at 590nm |
|---|---|---|---|---|---|---|
| Example 1 | 1700 | 1500 | 10⁻⁹ | Blue (partly green) | (50) | 70 |
| Example 2 | 2250 | 1500 | 10⁻⁹ | Blue | (60) | 90 |
| Example 3 | 6400 | 1500 | 10⁻⁹ | Blue | 110 | 200 |
| Example 4 | 10000 | 1500 | 10⁻⁹ | Blue | (120) | 250 |
| Example 5 | 13700 | 1500 | 10⁻⁹ | Blue | (130) | 570 |
| Comparative Example 1 | 850 | 1500 | 10⁻⁹ | Green | 30 | - |
| Comparative Example 2 | 6400 | None | - | Green (partly brown) | 110 | - |
| Comparative Example 3 | Fe:300 | None | - | Blue | - | - |
| | Ti:600 | | | | | |

The figures of cobalt concentrations in the parentheses were calculated from the transmittance. The results of ICP analysis could confirm that the aluminum oxide single crystals obtained in Example 1 to Example 5 contained 50 ppm to 130 ppm of cobalt relative to the number of aluminum atoms.

The colors of the aluminum oxide single crystals were observed. The aluminum oxide single crystal of Example 1 turned blue but was partly green. The aluminum oxide single crystals of Example 2 to Example 5 had a blue color.

In contrast, in Comparative Example 1, the aluminum oxide single crystal after the heat treatment contained 30 ppm of cobalt relative to the number of aluminum atoms and did not turn blue but green. In Comparative Example 2, the aluminum oxide single crystal not subjected to the heat treatment did not turn blue but green and partly brown.

The results described above show that an aluminum oxide single crystal having a blue color can be produced by growing a crystal by a flame fusion method using oxyhydrogen flame from a raw material having a cobalt concentration of 1700 ppm to 13700 ppm relative to the number of aluminum atoms, and then heat-treating the crystal at a temperature of 1500°C in an atmosphere having an oxygen partial pressure of 10⁻⁹ atm.

Although the blue aluminum oxide single crystal of the present invention may be obtained by omitting the heat treatment step and by controlling the atmosphere during the crystal growth, it is often difficult to control the atmosphere during growth, and color irregularity is often present in the aluminum oxide single crystals. Thus, by performing a heat treatment step, an aluminum oxide single crystal that has less color irregularity and that is blue even in the inside of the crystal can be obtained.

The cobalt content detected after the heat treatment is about one to two digits smaller than the cobalt content in the raw material used in growing the crystal, but this is considered to be caused by segregation. This is presumably because not much cobalt can be dissolved as solid solution in the crystal.

### Second embodiment

A method for producing an aluminum oxide single crystal according to this embodiment involves generating an aluminum oxide single crystal through a process of growing a single crystal by a Rotating and pulling method from a raw material which contains aluminum oxide as a main raw material and has a cobalt concentration of 5000 ppm to 20000 ppm relative to the number of aluminum atoms, and, then, a process of heat-treating the single crystal at a predetermined temperature in an atmosphere having an oxygen partial pressure of 10⁻⁶ atm to 10⁻⁹ atm.

Here, the predetermined temperature refers to a temperature equal to or higher than 1400°C and equal to or not more than the melting point of the aluminum oxide single crystal. When a heat treatment is performed at a temperature lower than 1400°C, it takes a long time for the aluminum oxide single crystal to turn blue. Meanwhile, although it is possible to perform a heat treatment at a high temperature equal to or lower than the melting point, it is often difficult to control the atmosphere at high temperature due to limitations posed by furnace materials and the like, and thus the temperature is preferably equal to or lower than 1800°C. Thus, in this embodiment, the heat treatment was performed at a temperature of 1400°C to 1800°C.

### (Example 6 to Example 13)

In Examples 6 to 13, a raw material (starting material) was prepared by mixing cobalt oxide with aluminum oxide so that the cobalt concentration relative to the number of aluminum atoms was 5000 ppm to 20000 ppm, and charged into a crucible. Then, a crystal was grown under the following conditions by using a rotating and pulling apparatus (also known as a Czochralski (CZ) method).
Pulling direction: [001]
Pulling rate: 0.5 mm/h
Crystal rotation rate: 10 rpm

A sample having a thickness of 3 mm was prepared by cutting and polishing the grown crystal so that the c-plane constituted a flat surface. Then the sample was heat-treated at 1400°C to 1800°C.

In heat-treating the sample at a temperature equal to or lower than 1600°C, the heat-treatment was performed at 1400°C to 1600°C for 50 hours in a tubular electric furnace formed of a high-purity alumina tube while causing a gas having a predetermined oxygen partial pressure (10⁻⁶ atm to 10⁻⁹ atm) to flow.

In heat-treating the sample at 1800°C, tungsten was used as a heater, and the heat-treatment was performed for 5 hours in an electric furnace covered with tungsten metal plates while causing a gas to flow so that the oxygen partial pressure was 10⁻⁹ atm.

As with the first embodiment, the oxygen partial pressure was adjusted by adding a predetermined proportion of hydrogen + water steam to nitrogen gas.

### (Comparative Example 4 to Comparative Example 6)

In Comparative Example 4, a raw material having a cobalt concentration of 3000 ppm relative to the number of aluminum atoms was prepared. Then, under the same conditions as Examples 6 to 13, a crystal was grown from the mixture by a Rotating and pulling method, and heat-treated at 1500°C in an atmosphere having an oxygen partial pressure of 10⁻⁹ atm. In Comparative Example 5, a raw material having a cobalt concentration of 10000 ppm relative to the number of aluminum atoms was prepared, and a crystal was grown by a Rotating and pulling method. However, a heat-treatment was not carried out after the crystal had been grown. In Comparative Example 6, a raw material having a cobalt concentration of 10000 ppm relative to the number of aluminum atoms was prepared, and a crystal was grown by a Rotating and pulling method. The grown crystal was heat-treated at 1500°C in an atmosphere having an oxygen partial pressure of 10⁻¹⁰ atm.

Observation of color, measurement of the transmittance, and the ICP analysis were performed on the aluminum oxide single crystals obtained in Examples and Comparative Examples. The results are shown in Table 2. Similar to Table 1, working curves were obtained from the obtained ICP analysis values and transmittances, and the estimate values of cobalt concentrations determined from the working curves are placed in parentheses.

**[Table 2]**

| | Cobalt concentration in raw material composition ppm(at) | Heat treatment temperature (°C) | Heat treatment atmosphere (pO₂:atm) | Color of crystal | Cobalt concentration ICP analysis value ppm (at) | Absorption coefficient α (m⁻¹) at 590nm |
|---|---|---|---|---|---|---|
| Example 6 | 5000 | 1500 | 10⁻⁹ | Green (partly blue) | (60) | 60 |
| Example 7 | 8000 | 1500 | 10⁻⁹ | Blue | (80) | 130 |
| Example 8 | 10000 | 1500 | 10⁻⁹ | Blue | (85) | 180 |
| Example 9 | 20000 | 1500 | 10⁻⁹ | Blue | (110) | 260 |
| Example 10 | 10000 | 1600 | 10⁻⁹ | Blue | (85) | 200 |
| Example 11 | 10000 | 1400 | 10⁻⁹ | Green (partly blue) | (85) | 80 |
| Example 12 | 10000 | 1800 | 10⁻⁶ | Blue | (85) | 200 |
| Example 13 | 10000 | 1500 | 10⁻⁸ | Green (partly blue) | (85) | 80 |
| Comparative Example 4 | 3000 | 1500 | 10⁻⁹ | Green | 26 | - |
| Comparative Example 5 | 10000 | None | - | Green | (85) | - |
| Comparative Example 6 | 10000 | 1500 | 10⁻¹⁰ | Brown | (85) | - |

The figures of cobalt concentrations in the parentheses were calculated from the transmittance. The results of ICP analysis could confirm that the aluminum oxide single crystals obtained in Example 6 to Example 13 contained 60 ppm to 110 ppm of cobalt relative to the number of aluminum atoms.

The colors of the aluminum oxide single crystals were observed. The aluminum oxide single crystal obtained in Example 6, Example 11, and Example 13 were green and partly blue. The aluminum oxide single crystals of other Examples were blue. It was found that the density of the blue color increased as the cobalt concentration relative to the number of aluminum atoms increased.

In contrast, in Comparative Example 4, the aluminum oxide single crystal after the heat treatment contained 26 ppm of cobalt relative to the number of aluminum atoms and did not turn blue but green. This shows that the aluminum oxide single crystal does not turn blue when the cobalt concentration in the starting material is lower than 5000 ppm relative to the number of aluminum atoms.

Furthermore, in Comparative Example 5, the aluminum oxide single crystal not subjected to the heat treatment did not turn blue but green although 85 ppm of cobalt was contained relative to the number of aluminum atoms. In Comparative Example 6, when the heat treatment was performed at an oxygen partial pressure of 10⁻¹⁰ atm, the aluminum oxide single crystal turned brown. This shows that the aluminum oxide single crystal does not turn blue when the oxygen partial pressure during the heat treatment is lower than 10⁻⁹ atm and when the oxygen partial pressure is higher than 10⁻⁶ atm.

The results described above show that an aluminum oxide single crystal having a blue color can be produced by growing an aluminum oxide single crystal by the Rotating and pulling method from a raw material having a cobalt concentration of 5000 ppm to 20000 ppm relative to the number of aluminum atoms, and then heat-treating the crystal at a temperature of 1400°C or higher and 1800°C or lower in an atmosphere having an oxygen partial pressure of 10⁻⁶ atm to 10⁻⁹ atm.

Similar to the first embodiment, although the blue aluminum oxide single crystal of the present invention may be obtained by omitting the heat treatment step and by controlling the atmosphere during the crystal growth, it is often difficult to control the atmosphere during growth, and color irregularity is often present in the aluminum oxide single crystals. Thus, by performing a heat treatment step, an aluminum oxide single crystal that has less color irregularity and that is blue even in the inside of the crystal can be obtained.

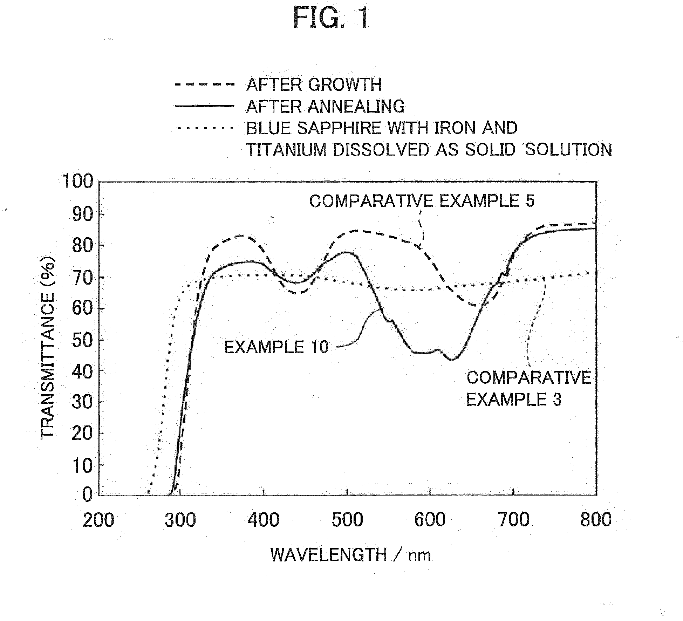

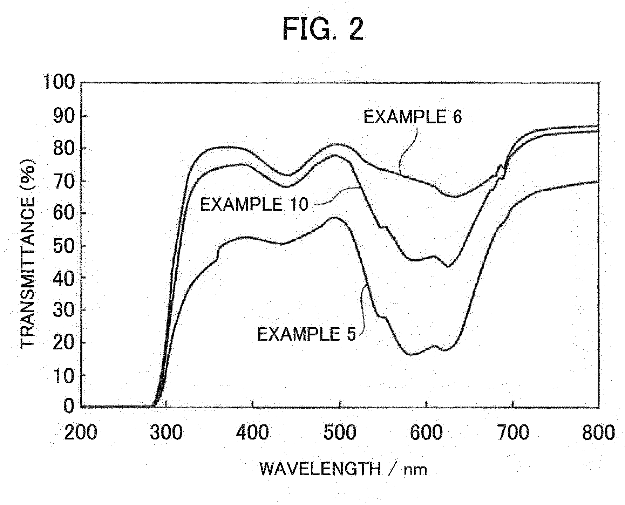

Next, the results of measuring the transmittance of the aluminum oxide single crystals prepared in the first embodiment and the second embodiment are shown in Figs. 1 and 2.

It was found that the aluminum oxide single crystal that turned blue (Example 10) had optical absorption peaks at 440 nm, 550 nm, 590 nm, and 630 nm, and absorbed light having a wavelength of 510 nm to 740 nm. It was found that, compared to the absorption peaks of the green aluminum oxide single crystal not subjected to the heat treatment (Comparative Example 5), the absorption at 440 nm, which is a blue wavelength, was low, and the absorption from 500 nm to 670 nm was high. Since 500 nm to 560 nm is green light, 560 nm to 600 nm is yellow light, and 600 nm to 750 nm is red light, the absorptions for the light of these wavelengths were high, and the blue color was intense and bright.

An aluminum oxide single crystal doped with iron and titanium (Comparative Example 3) has been known as blue sapphire and has a transmission spectrum with a broad absorption band from 500 nm to 700 nm, which indicates that a bright blue color is not obtained. It could be confirmed that the aluminum oxide single crystals of this embodiment had no absorption peak at 500 nm and had a blue color free of a red tinge.

Next, the absorption coefficient α at an absorption wavelength of 590 nm was calculated from the spectrum obtained by the transmittance measurement of the aluminum oxide single crystal prepared in this embodiment. The wavelength of 590 nm is a wavelength at which the absorption is high, and is easily compared with a green crystal. Since 590 nm is the wavelength of yellow light, the blue color, which is a complementary color of yellow, becomes intense if the absorption at a wavelength of 590 nm is high; thus, the absorption coefficient at this wavelength was calculated.

The absorption coefficient α of the aluminum oxide single crystal of the first embodiment at 590 nm was 70 m⁻¹ to 570 m⁻¹. Meanwhile, the absorption coefficient α of the aluminum oxide single crystal of the second embodiment at 590 nm was 60 m⁻¹ to 260 m⁻¹.

This shows that the absorption coefficient α of the blue aluminum oxide single crystal at 590 nm is in the range of 60 m⁻¹ to 570 m⁻¹, and the aluminum oxide single crystal has an intense blue color.

Although cobalt oxide was used as a color former in this embodiment, cobalt carbonate, cobalt oxalate, etc., can be used, for example. The oxygen partial pressure used in the heat treatment can also be adjusted by mixing a predetermined proportion of hydrogen + water steam or a predetermined proportion of carbon monoxide + carbon dioxide to an inert atmosphere gas such as argon, nitrogen, or the like.

### Industrial Applicability

A sapphire that is blue even in the inside can be produced by using only cobalt as a color former, and a blue sapphire of a practical size for use in accessories, watches, etc., can be produced at a reasonable cost.

## Claims

1. An aluminum oxide single crystal, wherein cobalt is used as a color former,
a cobalt concentration relative to the number of aluminum atoms is 50 ppm to 130 ppm, the aluminum oxide single crystal has a blue color,
wavelengths of optical absorption peaks are 440 nm, 550 nm, 590 nm, and 630 nm, light to be absorbed has a wavelength of 510 nm to 740 nm, and
an absorption coefficient at a wavelength of 590 nm is 60 m⁻¹ to 570 m⁻¹.

2. A method for producing an aluminum oxide single crystal, **characterized in that**,
the aluminum oxide single crystal according to Claim 1 is grown by a flame fusion method from a raw material containing aluminum oxide as a main raw material and having a cobalt concentration of 1700 ppm to 13700 ppm relative to the number of aluminum atoms.

3. A method for producing an aluminum oxide single crystal, **characterized in that**,
the aluminum oxide single crystal according to Claim 1 is grown by a rotating and pulling method from a raw material containing aluminum oxide as a main raw material and having a cobalt concentration of 5000 ppm to 20000 ppm relative to the number of aluminum atoms.

4. A method for producing an aluminum oxide single crystal, **characterized in that**,
after the process of growing the aluminum oxide single crystal according to Claim 2 or 3 is performed,
a process of performing a heat treatment at a predetermined temperature in an atmosphere having an oxygen partial pressure of 10⁻⁶ atm (0.1 Pa) to 10⁻⁹ atm (10⁻⁴ Pa) is performed.

## Patentansprüche

1. Aluminiumoxid-Einkristall, worin Kobalt als Farbbildner verwendet wird,
eine auf die Anzahl der Aluminiumatome bezogene Kobaltkonzentration 50 ppm bis 130 ppm beträgt, der Aluminiumoxid-Einkristall eine blaue Farbe hat,
die Wellenlängen der optischen Absorptionspeaks 440 nm, 550 nm, 590 nm und 630 nm sind, das zu absorbierende Licht eine Wellenlänge von 510 nm bis 740 nm hat und
ein Absorptionskoeffizient bei einer Wellenlänge von 590 nm 60 m⁻¹ bis 570 m⁻¹ beträgt.

2. Verfahren zur Herstellung eines Aluminiumoxid-Einkristalls, **dadurch gekennzeichnet, dass**
der Aluminiumoxid-Einkristall nach Anspruch 1 durch ein Flammenschmelzverfahren aus einem Rohmaterial gezüchtet wird, das Aluminiumoxid als Hauptrohstoff enthält und eine auf die Anzahl der Aluminiumatome bezogene Kobaltkonzentration von 1700 ppm bis 13700 ppm aufweist.

3. Verfahren zur Herstellung eines Aluminiumoxid-Einkristalls, **dadurch gekennzeichnet, dass**
der Aluminiumoxid-Einkristall nach Anspruch 1 durch ein Rotations- und Ziehverfahren aus einem Rohmaterial gezüchtet wird, das Aluminiumoxid als Hauptrohmaterial enthält und eine auf die Anzahl der Aluminiumatome bezogene Kobaltkonzentration von 5000 ppm bis 20000 ppm aufweist.

4. Verfahren zur Herstellung eines Aluminiumoxid-Einkristalls, **dadurch gekennzeichnet, dass**,
nachdem der Prozess der Züchtung des Aluminiumoxid-Einkristalls nach Anspruch 2 oder 3 durchgeführt wurde,
ein Verfahren zur Durchführung einer Wärmebehandlung bei einer vorbestimmten Temperatur in einer Atmosphäre mit einem Sauerstoffpartialdruck von 10⁻⁶ atm bis 10⁻⁹ atm durchgeführt wird.

## Revendications

1. Monocristal d'oxyde d'aluminium, dans lequel:
le cobalt est utilisé comme agent chromogène,
une concentration en cobalt par rapport au nombre d'atomes d'aluminium est comprise entre 50 ppm et 130 ppm, le monocristal d'oxyde d'aluminium présentant une couleur bleue,
des longueurs d'onde de pics d'absorption optique sont de 440 nm, 550 nm, 590 nm et 630 nm, la lumière à absorber présentant une longueur d'onde comprise entre 510 nm et 740 nm, et
un coefficient d'absorption à une longueur d'onde de 590 nm est compris entre 60 m⁻¹ et 570 m⁻¹.

2. Procédé de production d'un monocristal d'oxyde d'aluminium, **caractérisé en ce que** le monocristal d'oxyde d'aluminium selon la revendication 1 est développé par un procédé de fusion à la flamme à partir d'un matériau brut contenant de l'oxyde d'aluminium comme matériau brut principal et présentant une concentration en cobalt comprise entre 1700 ppm et 13700 ppm par rapport au nombre d'atomes d'aluminium.

3. Procédé de production d'un monocristal d'oxyde d'aluminium, **caractérisé en ce que** le monocristal d'oxyde d'aluminium selon la revendication 1 est développé par un procédé de rotation et traction à partir d'un matériau brut contenant de l'oxyde d'aluminium comme matériau brut principal et présentant une concentration en cobalt comprise entre 5000 ppm et 20000 ppm par rapport au nombre d'atomes d'aluminium.

4. Procédé de production d'un monocristal d'oxyde d'aluminium, **caractérisé en ce que**, une fois le procédé de développement du monocristal de l'oxyde d'aluminium selon la revendication 2 ou 3 effectué, un procédé de réalisation d'un traitement thermique à une température prédéterminée dans une atmosphère présentant une pression partielle d'oxygène comprise entre 10⁻⁶ atm (0,1 Pa) et 10⁻⁹ atm (10⁻⁴ Pa) est exécuté.
